# EUROPEAN PATENT APPLICATION

(11) **EP 2 487 214 A1**
(43) Date of publication of application: **15.08.2012**
(21) Application number: 12000684.6
(22) Date of filing: 02.02.2012
(51) Int. Cl.: C09J 7/02, H01L 21/683

(54) **Spontaneously rolling adhesive sheet and method of manufacturing a cut piece**

(30) Priority: 10.02.2011 JP 2011026803; 08.07.2011 JP 2011152173
(71) Applicant: Nitto Denko Corporation, Ibaraki-shi, Osaka 567-8680 (JP)
(72) Inventor: Kiuchi, Kazuyuki, Ibaraki-shi Osaka 567-8680 (JP); Nishio, Akinori, Ibaraki-shi Osaka 567-8680 (JP)
(74) Representative: Hager, Thomas Johannes

(57) **Abstract**

A spontaneously rolling adhesive sheet that can spontaneously roll from one end in one direction, or two opposed ends towards the center as a result of thermal stimulus to thereby form one or two cylindrical rolled bodies includes: a spontaneously rolling laminated sheet configured by lamination in the order of a shrinkable film layer which has a principal shrinking characteristic in one predetermined axial direction, a bonding adhesive layer and a rigid film layer, an adhesive layer laminated onto the rigid film layer side of the spontaneously rolling laminated sheet, and
an organic coating layer disposed between the rigid film layer and the adhesive layer.

## Description

### CROSS-REFERENCE TO RELATED APPLICATIONS

This application claims priority to Japanese Patent Applications No. 2011-26803 filed on February 10, 2011 and No. 2011-152173 filed on July 8, 2011. The entire disclosure of Japanese Patent Applications No. 2011-26803 and No. 2011-152173 is hereby incorporated herein by reference.

### BACKGROUND

### Technical Field

The present invention relates to a spontaneously rolling adhesive sheet and a method of manufacturing cut piece. More particularly, the present invention relates to a spontaneously rolling adhesive sheet that spontaneously rolls from an end towards the main axis of shrinkage in response to application of heat to thereby form a cylindrical rolled body, and a method of manufacturing a cut piece that uses the adhesive sheet.

### Related Art

In recent years, the demand for a reduction in thickness and a reduction in weight has increased in relation to semiconductor materials. A thickness of no more than 100 µm is used in a thin-film wafer for a semiconductor silicon wafer.
The extreme brittleness of this type of thin-film wafer results in a tendency for breakage, and during manufacturing processing steps such as dicing, a method is employed by which an adhesive sheet is adhered for the purpose of temporary fixation, or protecting the circuit forming surface or preventing contamination. In relation to this type of sheet, a spontaneously rolling adhesive sheet has been proposed, for example, which forms a UV-curing adhesive layer on a laminated sheet formed from a bonding adhesive layer and a rigid film layer that are laminated on one surface of a shrinkable film (see, for example, JP2010-194819A).
The spontaneously rolling adhesive sheet can peel from the semiconductor wafer as a result of spontaneous deformation into a cylindrical rolled body by reducing of the adhesive force of the adhesive layer through application of UV irradiation after dicing, which is attached to the semiconductor wafer prior to dicing, and by applying heat In this manner, the operation time for sheet peeling can be reduced.

However, the properties of a conventional spontaneously rolling adhesive sheet are insufficient in that partial peeling (anchor failure) is produced between the laminated sheet and the adhesive layer, and residual adhesive is present on the adherend.

### SUMMARY OF THE INVENTION

The present invention is proposed in light of the above problems, and has the object of providing a spontaneously rolling adhesive sheet that enables rapid peeling by a rolling operation and does not result in residual adhesive, and a method of manufacturing cut piece that uses the adhesive sheet.
The present inventors conducted diligent research into anchor failure of a conventional spontaneously rolling adhesive sheet, and gained the new insight that, although there is no occurrence when peeling is executed without rolling of the spontaneously rolling adhesive sheet, anchor failure is caused by various reasons, in addition to the configuration of the cylindrical rolled body resulting from spontaneous rolling, such as the dimensions and thickness of the adherend, the dimensions of the adhesive sheet when peeling, the adhesive force of the adhesive after UV curing, the thickness of the adhesive layer. The inventors gained the further new insight that effective prevention of anchor failure as described above is not obtained by a method in which a normal adhesive sheet is used, such as a method of increasing the chemical affinity between the adhesive layer and the base member, or a method of increasing the contact surface area between both components by the formation of minute indentations on the base member surface. The present invention was completed by repetition of trial and error in relation to a configuration of a spontaneously rolling adhesive sheet that enables effective inhibition of anchor failure in this type of adhesive sheet

The present invention includes inventions described below;
<1> A spontaneously rolling adhesive sheet that can spontaneously roll from one end in one direction, or two opposed ends towards the center as a result of thermal stimulus to thereby form one or two cylindrical rolled bodies comprising:
a spontaneously rolling laminated sheet configured by lamination in the order of a shrinkable film layer which has a principal shrinking characteristic in one predetermined axial direction, a bonding adhesive layer and a rigid film layer,
an adhesive layer laminated onto the rigid film layer side of the spontaneously rolling laminated sheet, and
an organic coating layer disposed between the rigid film layer and the adhesive layer.

<2> The spontaneously rolling adhesive sheet according to <1>, wherein the organic coating layer is formed from an urethane-based polymer or oligomer.
<3> The spontaneously rolling adhesive sheet according to <2>, wherein
the urethane-based polymer or oligomer of the organic coating layer is obtained by reacting a polyol compound, with a polyisocyanate compound that includes an equivalent amount or excess equivalent amount of isocyanate groups relative to the hydroxyl groups of the polyol compound.
<4> The spontaneously rolling adhesive sheet according to any one of <1> to <3>, wherein the adhesive layer is formed from an energy-curable adhesive.
<5> The spontaneously rolling adhesive sheet according to <4>, wherein the adhesive force of the adhesive layer relative to a silicon mirror wafer (25 degrees C, 180 degree peeling, tensile speed 300 mm/min) is at least 1.0 N/10mm prior to energy irradiation.
<6> The spontaneously rolling adhesive sheet according to <5>, wherein
the adhesive layer exhibits a Young's modulus after energy irradiation of 0.4 to 75 MPa at 80 degrees C.
<7> The spontaneously rolling adhesive sheet according to any one of <1> to <6>, wherein shrinkage ratio in the principal shrinking direction of the shrinkable film configuring the shrinkable film layer is 30 to 90 % in a predetermined temperature within 70 to 180 degrees C.
<8> The spontaneously rolling adhesive sheet according to any one of <1> to <7>, wherein product of the thickness of the rigid film layer by Young's modulus of the rigid film layer is no more than 3.0 x 10⁵N/m.
<9> The spontaneously rolling adhesive sheet according to any one of <1> to <8>, wherein the bonding adhesive layer is formed from an urethane-based bonding adhesive, and the peeling force when the shrinkable film layer is peeled away with the rigid film layer at 70 degrees C by 180 degree peeling and tensile speed 300 mm/min exhibits at least 2.0 N/10 mm.
<10> The spontaneously rolling adhesive sheet according to any one of <1> to <9>, wherein
ratio (rₙ/Lₙ) of the diameter of the rolled body rₙ and the length Lₙ in a rolled direction of the sheets is in the range of 0.001 to 0.333 when the spontaneous rolling adhesive sheet has either configuration of one or two cylindrical rolled bodies formed by spontaneous rolling.

<11> A method of manufacturing a cut piece comprising;
adhering the spontaneous rolling adhesive sheet of claim 1 to an adherend;
cutting the adherend into a small piece, and
removing the spontaneous rolling adhesive sheet by heating and peeling from the small pieces to obtain the cut piece.
<12> The spontaneously rolling adhesive sheet according to <11>, wherein
the adherend is a semiconductor wafer or an optical element protective member.

According to the present invention, it is possible to provide a spontaneously rolling adhesive sheet that enables rapid peeling by a rolling operation and does not result in residual adhesive.
Also, it is possible to manufacture a cut piece in an efficient way by using the spontaneously rolling adhesive sheet.

### BRIEF DESCRIPTION OF THE DRAWINGS

FIG. 1 is a schematic sectional view illustrating an example of a spontaneously rolling adhesive sheet according to the present invention.
FIG. 2A is a perspective view of a spontaneously rolling adhesive sheet according to the present invention.
FIG. 2B is a perspective view of a spontaneously rolled configuration of a spontaneously rolling adhesive sheet according to the present invention.
FIG. 2C is a perspective view of a spontaneously rolling adhesive sheet according to the present invention when a single cylindrical rolled body has been formed.
FIG. 2D is a perspective view of a spontaneously rolling adhesive sheet according to the present invention when two cylindrical rolled bodies have been formed.
FIG. 3 is a schematic sectional view and a plan view of the spontaneously rolling adhesive sheet to describe a method of bonding failure testing.
FIG. 4 is a schematic sectional view and a plan view of the spontaneously rolling adhesive sheet to describe a method of bonding failure.
FIG. 5 is a schematic sectional view and a sectional view of the principal portions including a wafer to describe a method of peeling testing.
FIG. 6 is a schematic sectional view of an adhesive sheet to describe a method of evaluating anchor failure.
FIG. 7A is a schematic sectional view of an adhesive sheet to describe anchor failure.
FIG. 7B is a schematic sectional view of an adhesive sheet to describe anchor failure.

### BRIEF DESCRIPTION OF THE EMBODIMENTS

The spontaneously rolling adhesive sheet according to the present invention (may be referred to below as "adhesive sheet") is mainly constituted by a spontaneously rolling laminated sheet, an adhesive layer, and an organic coating layer disposed between the sheet and the layer.
After adhesion to the adherend, this type of spontaneously rolling adhesive sheet spontaneously rolls from one end in one direction, or two opposed ends, towards the center as a result of thermal stimulus imparted at a predetermined timing to thereby form one or two cylindrical rolled bodies. The adhesive sheet can be rapidly peeled from an adherend by use of this rolling force. As a result, as described above, the spontaneously rolling laminated sheet that is used as the base member for the adhesive layer has a characteristic such that rolling occurs upon thermal stimulus and thereafter, re-attachment to the adherend due to roll back does not occur. One means of realizing this type of characteristic includes imparting of a predetermined rigidity to the base member.
However, the insight was obtained that this rigidity is effective in rolling of the adhesive sheet and prevention of roll back, on the other hand, the rigidity can cause conflicting characteristics concerning a tracking (following) of the adhesive layer to the base member, in particular, tracking at peeling and rolling. That is to say, a new phenomenon has been identified in which the mutual anchoring properties can be reduced without tracking of the thin-film adhesive layer to the rigid base member as a result of a configuration of the type or shape of the adherend, the composition, the adhesive force or the thickness of the adhesive layer, the timing of peeling, the peel speed, the peel angle, or the like.

The peeling of an adhesive sheet that uses deformation into a cylindrical rolled body as described above corresponds to peeling at a large angle, and this means that the peel stress is reduced. This type of reduction in the peel stress means that the adhesive force on the adherend during peeling is reduced and, at the same time, means that there is a conspicuous reduction in the anchor characteristics between the adhesive layer and the base member. When coupled with the rigidity of the base member, anchoring characteristics between the two members is more difficult to ensure.

In relation to the above problems, the present invention has the objective of providing the adhesive sheet that ensures mutual anchoring characteristics between the adhesive layer and the base member by an extremely simple configuration, that enables effective prevention of residual adhesive during peeling of the adhesive sheet as a result of rolling, and that enables more rapid and accurate manufacture of a final product More particularly, when using a brittle adherend, damage to the adherend can be effectively prevented by reducing the peel stress.

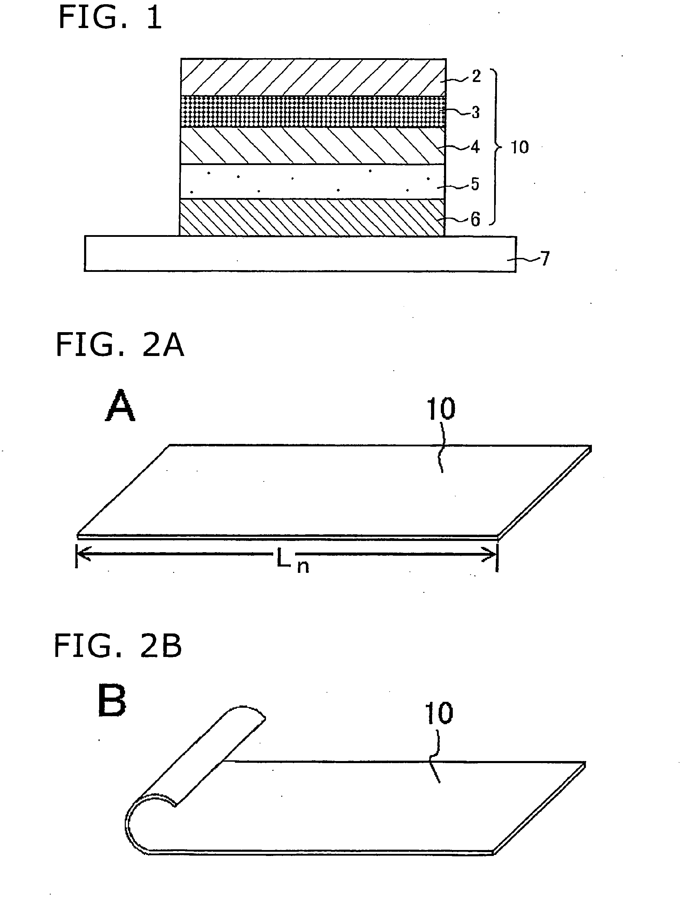

As shown in FIG.1, the spontaneously rolling adhesive sheet 10 according to the present invention is mainly configured by a spontaneously rolling laminated sheet including a shrinkable film layer 2, a bonding adhesive layer 3 and a rigid film layer 4 that are laminated in order, and an adhesive layer 6. An organic coating layer 5 is disposed between the rigid film layer 4 and the adhesive layer 6 in contact with both layers. The spontaneously rolling adhesive sheet 10 is used by adhering the adhesive layer 6 to the adherend 7.
The spontaneously rolling laminated sheet enables adjustment of the direction of shrinkage of the adhesive sheet as a result of the shrinkage of the shrinkable film layer. For example, rolling in one axial direction is realized by shrinkage in one direction, and extremely simple and superior peeling of the adhesive sheet from the adherend is enabled by rapid formation of a cylindrical rolled body.

This configuration, that is to say, a simple configuration in which the organic coating layer is disposed on the rigid film layer enables unexpectedly effective prevention of anchor failure between the rigid film layer and the adhesive layer even after minimization of the peel stress of the adhesive layer during peel. Maintenance of mutual anchoring performance by only the disposition of this type of organic coating layer is an unexpected effect upon consideration of the fact that such an effect has not been achieved as described above by a method that uses a normal adhesive sheet and increases the contact surface area, improves the chemical affinity between the adhesive layer and the base member, or the like.
This effect is effective for peeling after dicing of a semiconductor wafer or a semiconductor devices. In particular, damage to the adherend can be avoided during peeling from an extremely small piece of a semiconductor wafer after dicing, or peeling in a configuration in which damage tends to result due to an extremely slight stress because of thin film formation of the semiconductor wafer or the like that acts as the adherend. The effect is extremely useful in relation to realizing peeling from a plurality of extremely small pieces in an extremely short time.

### <Shrinkable Film Layer>

The shrinkable film layer in the adhesive sheet according to the present invention plays the role of generating counteracting parallel forces in the sheet as a torque as a result of a shrinkage stress produced by shrinkage caused by stimulus and creating a counteracting force in the rigid film as described below.
The shrinkable film layer may be a film layer that has shrinking characteristics in at least one axial direction, and may have any configuration including a film that shrinks in response to heat, a film that shrinks in response to light, a film that shrinks as a result of electrical stimulus, or the like. Of the above configurations, a film that shrinks in response to heat is preferred in view of the fact that there are many options for selection of the heat source for thermal stimulus, or in view of applicability and a broad range of applications.

When the shrinkable film layer has a principal shrinking characteristic in one predetermined axial direction, a secondary shrinking characteristic may be provided in a different direction to the first direction (for example, a direction that is orthogonally disposed to that direction).
The shrinkable film layer may be a single layer, or may be a plurality of layers formed from two or more layers.
The shrinkage ratio in the principal shrinking direction of the shrinkable film configuring the shrinkable film layer is preferably 30 to 90 %.
For example, when the shrinkable film layer is configured by a film that shrinks in response to heat, the shrinkage ratio in the principal shrinkage direction of the film that shrinks in response to heat is preferably 30 to 90% in a predetermined temperature range of 70 to 180 degrees C (for example 95 degrees C, 140 degrees C, or the like).
As used herein, the shrinkage ratio means a value that is calculated using the equation [(dimensions prior to shrinkage - dimensions after shrinkage)/dimensions prior to shrinkage] x 100.

The shrinkable film layer, for example, can be formed from a uniaxially stretched film, and formed from one type or at least two types of resin selected from the group comprising of a polyester-based resin such as polyethylene terephthalate; a polyolefin-based resin including a cyclic polyolefin-based resin such as polyethylene, polypropylene, polynorbornene; a polyimide-based resin; a polyamide-based resin; a polyurethane-based resin; a polystyrene-based resin; a polyvinylidene chloride-based resin; a polyvinyl chloride-based resin; or the like. Of the above, use of a uniaxially stretched film formed from a polyester-based resin, a polyolefin-based resin, or a polyurethane-based resin is preferred in view of superior coating performance in relation to the adhesive, and in particular a uniaxially stretched film formed from a polyester-based resin is preferred.

This type of shrinkable film layer includes commercially available products such as "Spaceclean (Registered trademark)" manufactured by Toyobo Co., Ltd., "Fancy Wrap (Registered trademark)" manufactured by Gunze Limited, "Torayfan (Registered trademark)" manufactured by Toray Industries, "Lumirror (Registered trademark)" manufactured by Toray Industries, "Arton (Registered trademark)" manufactured by JSR, "Zeonor (Registered trademark)" manufactured by Japan Zeon Corporation, "Suntec (Registered trademark)" manufactured by Asahi Chemical Industry Co., Ltd., "HISHIPET (Registered trademark)" manufactured by Mitsubishi Plastics, or the like. Of the above, "Spaceclean (Registered trademark)" and "HISHIPET (Registered trademark)" are preferred. Since these products are superior when compared other heat shrinking films such as polyolefin-based resins, or the like, due to superior coating performance, high coating accuracy (thickness), and a dimensional change due to shrinking at room temperature (low-temperature thermal shrinkage).
When an energy-curable adhesive as described below is used as the adhesive layer for the spontaneously rolling adhesive sheet, curing the energy-curable adhesive is performed by passing the radiant energy beams through the shrinkable film layer, and therefore the shrinkable film layer is preferably configured from a material enabling transmission of at least a predetermined amount of energy beams (for example, a material enabling transmission of at least 90%, at least 80%, at least 70% of the used energy beams such as a resin having transparent characteristics, i.e., translucent).

Generally, the shrinkable film layer suitably has a thickness of 5 to 300 µm, and when the bonding operation using the bonding adhesive as described below is considered, a thickness of 10 to 100 µm, and furthermore 10 to 60 µm is preferred. In this manner, an excessive increase in rigidity can be prevented, adhesion onto the adherend is facilitated, and spontaneous rolling can be promoted. Coupled with the bonding adhesive layer described below, separation between the shrinkable film layer and the rigid film layer described below can be inhibited, and damage to the bonding adhesive layer can be effectively prevented. Furthermore, an elastic deformation force that occurs due to residual stress during adhesion of the adhesive sheet can be inhibited, and warping with respect to the extremely thin wafer can be prevented.

The surface of the shrinkable film layer may be subjected to a typical surface processing such as a chemical or physical processing including chromic acid processing, ozone exposure, flame exposure, high-voltage shock exposure, ionizing radiation processing, or the like, or a coating process using a primer agent, or the like (for example, an adhesive substance or the like) in order to enhance the tight adhesion performance, retention performance or the like with adjacent layers.

### <Bonding Adhesive Layer>

The bonding adhesive layer in the adhesive sheet according to the present invention plays the role of bonding the shrinkable film layer with the rigid film layer described below, and is suitably configured with a sufficiently high adhesive force for bonding both those layers.
In particular, a configuration is suitable in which a high adhesive force can be maintained and a reduction in the adhesive force does not result even when high temperature/ high heat, energy irradiation or the like is applied to shrink the shrinkable film layer.
It is preferred that the bonding adhesive layer does not deform under shrinkage as a result of the shrinkage stress produced by the shrinkable film layer due to the production of a large torque caused by stimulus by heating or the like. Furthermore, a low thickness is preferred. In this manner, the bonding adhesive layer is preferably thin, hard and exhibits a high adhesive force to thereby satisfy the mutually contrary physical properties.

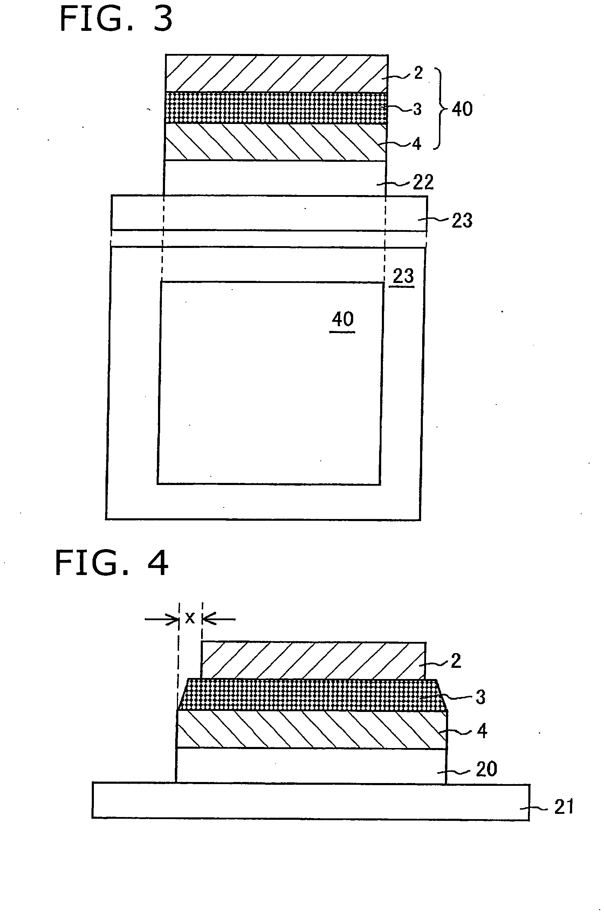

In this manner, the bonding adhesive layer is preferably configured so that bonding does not fail even after application of thermal stimulus by heating at 70 to 180 degrees C for about 3 minutes.
For example, the feature of non-failure of bonding may be confirmed visually using one of the following methods.
As illustrated in FIG. 3, the spontaneously rolling adhesive sheet 40 is cut into 30 mm x 30 mm pieces, the rigid film layer 4 is bonded to a SUS plate 23 having a thickness of 2 mm using HYPERJOINT HJ8008 manufactured by Nitto Denko Corporation as an adhesive 22, and fixed so as not to deform into a rolling configuration by heating. This configuration is left for three minutes in a counter current canal drier (convective drier) at 170 degrees C, removed, and subjected to visual observation. Normally, as illustrated in FIG. 4, the shrinkable film layer 2 shrinks due to heating. A level that enables visual confirmation of bonding failure is preferably set to at least 0.5 mm as a distance x. The distance x means a distance from the end of the rigid film layer 4 to the end of the shrinkable film layer 2 that has undergone shrinking.

The peeling force for the bonding adhesive that forms the bonding adhesive layer is suitably at least 2.0 N/10 mm when the shrinkable film layer is peeled away with the rigid film layer side in a fixed configuration in the adhesive sheet according to the present invention Furthermore, a value of 2.5 N/10 mm is preferred. In this manner, even during actual peeling of the adhesive sheet, bonding failure with the rigid film layer by a shrinkage stress of the shrinkable film layer described above can be prevented. The adhesive force at this time can be measured by a 180 degree peel test (tensile speed: 300 mm/min) at 70 degrees C.

The bonding adhesive layer preferably has a shear storage elastic modulus (G') at 80 degrees C of at least 0.35 MPa as an elastic modulus to express hardness, with a value of at least 0.8 MPa being preferred. The shear storage elastic modulus is a value that is measured using the following method.
After preparing the adhesive layer with a thickness of 1.5 mm to 2 mm, cutting out is executing using a punch with a diameter of 7.9 mm to configure a measurement test sample.
Measurements were performed using a chucking pressure of 100 g-weight, and a shear of a 1 Hz frequency with a viscoelasticity spectrometer manufactured by Rheometric Scientific (ARES) (using a stainless steel 8 mm parallel plate, Model 708.0157 manufactured by T A Instruments Company]. The shear storage elastic modulus (G') at 80 degrees C is used.

The bonding adhesive layer has typically a thickness of substantially 0.01 to 15 µm, and preferably 0.1 to 10 µm. In this manner, the normally required adhesive strength can be maintained. Furthermore, prevention of an increase in rigidity above that which is required enables effective use as a peeling force without waste in order to roll the produced torque. In addition, a stress mitigation function is enabled for inhibiting warping of the adherend due to the adhesive stress. Furthermore, cleaving characteristics in the adhesive sheet are superior and protrusion of the bonding adhesive layer can be prevented. The stress mitigation function can be controlled by the material used in the bonding adhesive layer, and various characteristics in addition to the thickness.

There is no particular limitation to the bonding adhesive as long as a material having the above characteristics is employed, and for example, although a cross-linking acrylic adhesive as disclosed in Japanese Patent Application Laid-Open No. 2008-155619 is used, a urethane bonding adhesive that is generally used as a dry-laminate bonding adhesive is preferred.
The urethane bonding adhesive is a bonding adhesive that is a mixture of a compound having a hydroxyl group and a compound having an isocyanate group as a functional group, and that produces a urethane-based bonding adhesive as a result of a chemical reaction. Since the urethane bonding adhesive includes a strong hydrogen bond, the molecular interaction with the adherend molecules is strong, and a suitable configuration is obtained for attachment of a film formed in particular from a polar material. Furthermore since the intermolecular force between the bonding adhesive molecules is strong, softness tends not to result even when the bonding adhesive is heated, and the temperature dependency is low.

An aliphatic urethane that exhibits high thermal stability is preferred for use as the urethane bonding adhesive. Furthermore, combination is preferred of a portion exhibiting rigidity due to the cyclic backbone with a flexible backbone having a strong action of curving the molecular chain such as an ester bond or ether bond.
More precisely, use is possible of "TAKELAC" (registered Trademark) or "TAKENATE" (registered Trademark) manufactured by Mitsui Chemicals, "Seikabond" (registered Trademark) manufactured by Dainichi Seika, "TM569" manufactured by Toyo-Morton, or the like.

When the bonding adhesive layer is laminated, normally the bonding adhesive is coated onto the rigid film layer described below or the shrinkable film layer. The method of coating may be suitably selected from a known method in response to a desired thickness in which the method includes a method of using a Meyer bar, an applicator, or the like, or a method used in industrial production employing a fountain die, gravure coater, or the like.
The bonding adhesive may be coated onto a suitable release liner (separator) to thereby form a bonding adhesive layer, and then transferred (moved) onto the shrinkable film layer or the rigid film layer.

### <Rigid Film Layer>

The rigid film layer in the adhesive sheet according to the present invention plays the role of producing a countering acting force to the shrinkage force of the shrinkable film layer, whereby producing the required torque for rolling.
Due to the lamination of the rigid film layer, when stimulus such as heat is applied to impart shrinkage to the shrinkable film layer, the adhesive sheet can smoothly undergo spontaneous rolling to form a temporary cylindrical rolled body with a proper shape without the rolling or shrinking stopping midway and without any shift in the orientation of rolling or shrinking. Therefore, the rigid film preferably has rigidity not only at room temperature but also at the peeling temperature.

The rigid film, for example, can be formed from one type, or two or more types of resin selected from the group comprising of a polyester-based resin such as polyethylene terephthalate, polybutylene terephthalate, polyethylene naphthalate; a polyolefin-based resin such as polyethylene, polypropylene; a polyimide-based resin; a polyamide-based resin; a polyurethane-based resin; a polystyrene-based resin; a polyvinylidene chloride-based resin; a polyvinyl chloride-based resin; or the like. Of the above, the rigid film that configures the rigid film layer preferably includes a polyester-based resin film, a polyolefin-based such as a polypropylene film, a polyamide-based resin film, or the like in view of superior coating processing characteristics of the organic coating layer described below and/or the bonding adhesive. In particular, polyethylene terephthalate that is associated with large-scale cost-effective industrial application is preferred.
The rigid film layer may be a single layer, or a composite layer in which two or more layers are laminated.

The rigid film that configures the rigid film layer is typically non-shrinkable, and, for example, the shrinkage ratio is 5% or less, preferably 3% or less, and still more preferably 1% or less.

The product of the thickness by Young's modulus of the rigid film layer (Young's modulus x thickness) is preferably no more than 3.0 x 10⁵N/m (for example, 1.0 x 10² to 3.0 x 10⁵N/m) at the peeling temperature (for example, 80 degrees C), and more preferably no more than 2.8 x 10⁵N/m (for example, 1.0 x 10³ to 2.8 x 10⁵N/m. In this manner, an action in which the shrinkage stress of the shrinkage film layer is converted to a rolling stress and an orientation convergence action can be maintained. Furthermore, excessive rigidity can be prevented, and when coupled with the thickness of the bonding adhesive layer as described above, rapid rolling can be promoted.

The Young's modulus of the rigid film layer is preferably 10 GPa or less at the peeling temperature (for example, 80 degrees C), and more preferably 5 GPa or less. When the Young's modulus is within this range, spontaneous rolling can be promoted, and a rolled cylindrical body with a proper shape can be obtained. For example, Young's modulus may be measured using the method specified in JIS-K7127.

The thickness of the rigid film layer is typically 5 to 100 µm, and preferably 8 to 50 µm. In this manner, spontaneous rolling can be ensured, and a rolled cylindrical body with a proper shape can be obtained. In addition, handling performance and cost effectiveness can be improved. The rigid film layer is preferred a layer that is enabling simple adjustment of the thickness and has superior formation processing into a film configuration, in view of manufacturing performance and operating characteristics.

As described below, although an energy-curable adhesive is typically used as the adhesive in the spontaneously rolling adhesive sheet, when curing the energy-curable adhesive, since energy irradiation is executed through the rigid film layer, the rigid film layer is preferably configured using a material that enables at least a predetermined level of transmission of energy beams (a material enabling transmission of at least 90%, at least 80%, at least 70% of the energy beams, for example, a translucent resin or the like).

### <Spontaneously Rolling Laminated Sheet>

The spontaneously rolling laminated sheet according to the present invention is configured by lamination in the order of the shrinkable film layer, the bonding adhesive layer and the rigid film layer as described above. Although the shrinkable film layer, the bonding adhesive layer and the rigid film layer may be combined in an arbitrary manner, a combination of either the spontaneously rolling laminated sheet or the spontaneously rolling adhesive sheet as disclosed in Japanese Patent Application Laid-Open No. 2008-155619 may be used.
The spontaneously rolling laminated sheet does not undergo substantially shrinkage even after application of thermal stimulus, or the shrinkage ratio is no more than 10%, preferably no more than 5%, or more preferably no more than 2%.

### <Organic Coating Layer>

The organic coating materia is required to exhibit tracking (i.e., following) in response to the deformation of the film by close and superior attachment to the rigid film layer. Furthermore, the spontaneously rolling adhesive sheet according to the present invention, that is to say, the rigid film layer is required to undergo close and superior attachment to the adhesive layer. In particular, when the adhesive layer is formed from an energy-curable adhesive, it is required that anchor failure of the adhesive layer does not occur after curing with energy beams, and furthermore after peeling.
The occurrence or absence of anchor failure may be evaluated, for example, by a method described in the examples.

The organic coating layer is not limited to the only above characteristics, and any material may be used. For example, various coating materials may be used as described for example in the literature (Plastic Hard Coating Materials II, CMC Publications, 2004).
Of such materials, a urethane-based polymer or oligomer is preferred. This is due to the fact that excellent anchoring characteristics are exhibited in relation to the adhesive layer (in particular, an energy-curable adhesive layer after curing with energy beams), in addition, excellent close attachment to the rigid film layer and tracking characteristics during film deformation are exhibited.
In particular, polyacrylate urethane, polyester polyurethane, or precursors thereof are still more preferred. These materials may be acquired in a cost effective manner, enable selection of a range of industrially applicable types, and are exhibit applications in relation to convenient coating or painting of the rigid film layer.

Either polyacrylate urethane may used as described in the literature (Plastic Hard Coating Materials II, pages 17 to 21, CMC Publications, 2004) or the literature (Leading Edge Polyurethane Materials and Applications, CMC Publications, 2005). These polymers are formed from a reaction mixture that includes an isocyanate monomer and an alcoholic hydroxy group-containing monomer (for example, a hydroxy group-containing acrylate compound, or a hydroxy group-containing ester compound). Other components may include a chain extension agent such as a polyamine, an anti-aging agent, an antioxidant agent, or the like.
The polyacrylate urethane may be adjusted by reaction with a monomer as described above, and may include use of many substances commercially available or used as a coating material or an ink, a binder resin for a coating (refer to literature: Leading Edge Polyurethane Materials and Applications, page 190, CMC Publications, 2005). This type of polyurethane includes commercial products such as "NB300" manufactured by Dainichi Seika, "ADEKA BONTIGHTER" (registered Trademark) manufactured by ADEKA, "TAKELAC" (registered Trademark) A/ "TAKENATE (registered Trademark) A" manufactured by Mitsui Chemicals, "UC sealer" manufactured by DIC Graphics, or the like.
These types of polymers may be printed onto the rigid film layer as an ink by addition of a colorant or the like. This type of printing improves the design characteristics of the adhesive sheet.

The reason for the superior tight attachment and tracking characteristics exhibited by the urethane polymer or oligomer, and in particular the polyacrylate urethane and the polyether urethane, in relation to the rigid film layer is thought to result from the formation of strong bonds by reaction of the isocyanate component contained as a monomer with the polar functional group such as a hydroxyl group or a carboxyl group that is present on the rigid film surface.
Furthermore, in particular, the reason for the increase in anchoring performance with the energy-curable adhesive after irradiation with energy beams is thought to result from the formation of strong bonds by reaction of species of radicals produced in the energy-curable adhesive with the species of radicals produced in proximity to the urethane bonds during irradiation with energy beams (reference is made to literature: Structure of Polyurethane, Physical Properties, High Functionality, and Development of Applications, pages 191- 194, Technical Information Institute, Co., Ltd., (1999)).

The urethane polymer or oligomer described above is preferably obtained by reacting a polyol compound with a polyisocyanate compound that includes an equivalent amount (or equivalent mole number), or excess equivalent amount (or mole number) of isocyanate groups relative to the hydroxyl groups of the polyol compound, and is more preferably obtained by reacting a polyol compound with a polyisocyanate compound that includes an excess equivalent amount (or mole number) of isocyanate groups that is greater than the equivalent amount (or equivalent mole number) relative to the hydroxyl groups of the polyol compound. In this manner, the use of a polyisocyanate compound that includes a greater than or equal amount of isocyanate groups relative to the hydroxyl groups of the polyol compound enables enhancement of the inhibition of anchor failure, and in particular is preferred as a material for formation of the organic coating layer of the present invention.
More specifically, the mixing ratio of the isocyanate groups in the polyisocyanate relative to the hydroxyl groups of the polyol compound (NCO/OH) may be one or greater, and is preferred when greater than one. It may be suitably selected in view of manufacturing conditions for the adhesive sheet such as the coating or bonding step, or the softening temperature, the modulus of elasticity, the viscosity of the constituent material of the resulting organic coating layer, or the like. In particular, the mixing ratio is preferably 1.005 to 1000, more preferably 1.01 to 100, and still more preferably 1.05 to 10.

This is due to the fact that an equivalent amount or excess amount of the isocyanate group is expected to undergo chemical bonding with functional groups in the component contained in the rigid film layer or the adhesive layer. For example, when using a PET base as the rigid film layer, the PET base material contains a functional group that that includes active hydrogen such as a hydroxyl group or carboxyl group, or the like, and these groups undergo a reaction with the isocyanate group (or excess amount of isocyanate groups) in the organic coating layer to thereby form a urethane bond or amide bond. Furthermore, even in an adhesive layer that uses an adhesive such as a carboxyl group or an amino group, corresponding bonds are formed by active hydrogen in the same manner.
That is to say, it can be expected that the tight attachment characteristics will be improved by these bonds, and inhibition of anchor failure will be effective.

In light of the above, when a material containing the addition of a compound that has a functional group as described above or a material containing a functional group that includes active hydrogen is used in relation to the adhesive layer described below and/or the rigid film layer, in particular, there is the possibility of enhancement in the effect of inhibiting the anchor failure. The functional group containing active hydrogen includes a urethane group, a urea group, a thiol group, and the like in addition to the groups discussed above, and when respectively reacted with an isocyanate group, a chemical bond such as an allophanate bond, a burette bond, a thiourethane bond, or the like can be formed.

The polyol compound is preferably a compound which contains one or more (it is more preferable more than 1 preferably 2 or more) hydroxyl groups in equal 1 molecules on the average. Examples of the polyol compound include diol compounds such as ethylene glycol, propylene glycol; polymer polymerized by polyethylene glycol, polypropylene glycol, hydroxyl group-containing acrylic acid and the relatives (including, e.g., hydroxy ethyl acrylate, hydroxy ethyl metacrylate); or the like. The polyol compound may be suitably selected in view of manufacturing conditions because of a wide variety of boiling point (melting point), viscosity or the like.

The polyisocyanate compound is preferably a compound which contains one or more (it is more preferable more than 1 preferably more than 2) isocyanate groups in equal 1 molecules on the average. Examples of the polyisocyanate include diiisocyanate compounds such as xylylene diisocyanate, hexamethylene diisocyanate, tolylene diisocyanate, methylene bis(phenyl isocyanate); polyphenylene polyisocyanate (poly MDI); polypropylene glycol that the polymerization end is tolylene diisocyanate; or the like.
The polyisocyanate compound may be suitably selected in view of manufacturing conditions because of a wide variety of boiling point (melting point), viscosity or the like.

There is no particular limitation on the thickness of the organic coating layer, for example, the organic coating layer suitably has a thickness of 0.1 to 10 µm, a thickness of 0.1 to 5 µm, and furthermore 0.5 to 5 µm is preferred.

### <Adhesive Layer>

The adhesive layer in the adhesive sheet according to the present invention has adhesive characteristics that enable adhesion to the adherend, and after completion of the predetermined role, for example, is preferably adapted for use as an adhesive layer having repeelable characteristics that reduce or eliminate adhesion with an adhesion reduction process.

This type of adhesive layer that has repeelable characteristics can be used in relation to the same configuration as the adhesive layer of a known repeelable adhesive sheet.
In light of spontaneous rolling characteristics, the adhesive force of the adhesive layer relative to a silicon mirror wafer (25 degrees C, 180 degree peeling, tensile speed 300 mm/min) is typically at least 1.0 N/10mm (more particularly, at least 1.5 N/10mm), and no more than 18 N/10mm (more particularly, no more than 12 N/10mm). The adhesive force in the adhesive layer within this range may be an initial value, or a value during adhesion or prior to peeling. After adhesion reduction processing of the adhesive layer, for example, by irradiation with energy, the adhesive force preferably exhibits the value which is no more than the predetermined value described below.

In light of the above considerations, the adhesive configuring the adhesive layer is particularly preferably an energy-curable adhesive.
The energy-curable adhesive preferably uses a material that has adhesive characteristics that are relatively high during an initial period, is cured by irradiation with energy beams such as infrared radiation, visible light, ultraviolet radiation, X rays, electron beams or the like, and that has high elasticity through formation of a three dimensional network structure, in particular, by irradiation with ultraviolet radiation,.
The adhesive force described above in the energy-curable adhesive is typically the value prior to irradiation with energy. After irradiation with energy, the value is preferably no more than 6.5 N/10mm, and still more preferably no more than 6.0 N/10mm.
Furthermore, irrespective of the value prior to energy irradiation, the energy-curable adhesive preferably exhibits a Young's modulus after energy irradiation at 80 degrees C of 0.4 to 75 MPa, and more preferably 1 to 25 MPa.
The Young's modulus of the adhesive layer after energy irradiation (80 degrees C) for example may be measured using the following method.
The tensile testing system is an autograph AG-1kNG manufactured by the Shimadzu Corporation (including an attached heating hood). The adhesive layer after energy irradiation which was cut into a size having a length of 50 mm and a width of 10 mm was mounted between a chuck at a distance of 10 mm. After subjecting to an 80 degree C atmosphere with the heating hood, the cut test piece was drawn at a tensile speed of 5 mm/min to thereby obtain a measurement value for the stress-strain function. Young's modulus was obtained by calculating the load in relation to the two points at which the strain is 0.2% and 0.45%.

The energy-curable adhesive contains a compound including chemically modified functional groups that react with energy beams in order to impart curing characteristics imparted by energy beams, an energy-curable compound, or an energy-curable resin, or the like.
Therefore, the energy-curable adhesive is preferably configured by a base material (adhesive agent) which is chemically modified by energy-reactive functional groups, or a combined substance in which an energy-curable compound or an energy-curable resin is mixed into the base material.

A known stickum such as a pressure sensitive adhesive or an adhesive can be used as the base material of the energy-curable adhesive.
Examples of the base material include a rubber-based adhesive which contained a base polymer of rubber-based polymer, such as natural rubber, polyisoprene rubber, stylene-butadien rubber, stylene-isoprene block copolymer rubber, reclaimed rubber, butyl rubber, poryisobutylene rubber, NBR or the like; a silicone-based adhesive, an acrylic-based adhesive, or the like. These materials may be used singly or in combinations of two or more materials. Among these, an acrylic-based adhesive is preferable.

Examples of the acrylic-based adhesive include a homopolymer or copolymer of a C₁ to C₂₀ alkyl (meth)acrylate, such as methyl (meth)acrylate, ethyl (meth)acrylate, propyl (meth)acrylate, isopropyl (meth)acrylate, butyl (meth)acrylate, isobutyl (meth)acrylate, sec-butyl (meth)acrylate, tert-butyl (meth)acrylate, pentyl (meth)acrylate, isopentyl (meth)acrylate, 2-ethylhexyl (meth)acrylate and octyl (meth)acrylate; an acrylic-based adhesive which uses a acrylic polymer such as copolymer of the alkyl (meth)acrylic acid and other copolymerizable monomer, or the like as a base polymer. These adhesives can be used alone or as mixture of two or more adhesives.
Examples of such other copolymerizable monomer include, for example, a carboxyl- or acid anhydride-containing monomer such as acrylic acid, methacrylic acid, itaconic acid, fumaric acid and maleic anhydride; a hydroxyl group-containing monomer such as 2-hydroxyethyl (meth)acrylate; an amino-containing monomer such as morpholino (meth)acrylate; an amide-containing monomer such as (meth)acryl amide; vinyl acetate; acrylonitrile; or the like.

The energy-curable reactive functional group used for chemical modification includes a functions group that has carbon-carbon double bonds such as an acryloyl group, a methacryloyl group, a vinyl group, an allyl group, an acetylene group, or the like. These groups may be used singly or in combinations of two or more. These functional groups produce a radical by cleaving of the carbon-carbon double bonds by irradiation with an energy beam, and the radicals act as a cross linking point to thereby form a three dimensional network structure.
Of these compounds, a (meth)acryloyl group is preferred due to exhibiting relatively high reactivity in response to energy irradiation, and due to enabling use in combination with a range selected from acrylic adhesives or the like.

Typical examples of the base material chemically-modified with energy-reactive functional group include a polymer which is obtained by;
copolymerizing the a monomer containing the reactive functional group such as a hydroxyl group and/or carboxy group [e.g., 2-hydroxyl acrylate, (meth)acrylate] with an alkyl (meth)acrylate to form a reactive functional group-containing acrylic copolymer, and then
polymerizing the reactive functional group-containing acrylic copolymer with a compound containing a group that reacts with the reactive functional group (e.g., isocyanate group, epoxy group) and an energy reactive functional group (e.g., acryloyl group, methacryloyl group) in its molecule (such as (meth)acryloyl oxyethylene isocyanate or the like).
The proportion of the monomer containing the reactive functional group in the acrylic-based polymer containing reactive functional group is preferably 5 to 40 wt%, and more preferably 10 to 30 wt% by weight relative to the total monomers.

When reacting with the acrylic-based polymer that contains a reactive functional group, the used amount of the compound that has a group that reacts with the reactive functional group and the energy reactive functional group is for example 20 to 100 mol%, and preferably 40 to 95 mol% relative to the reactive functional group (hydroxyl group, carboxyl group, or the like) in the acrylic-based polymer that contains a reactive functional group. Furthermore, a reaction (addition reaction) between the compound containing the group that reacts with the reactive functional group and an energy reactive functional group, and the reactive functional group in the acrylic-based polymer may be promoted by addition of a catalyst such as an organic metallic compound such as organotin, organozirconium, or the like, or an amine compound, or the like.

Examples of the energy-curing compound include a compound having two or more of the carbon-carbon double bond such as poly(meta) acryloyl group containing compound, for example, trimethylolpropane tri(meth)acrylate, tetramethylol methane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate, polyethyleneglycol diacrylate, or the like. These compounds can be used alone or as mixture of two or more compounds. Of these compounds, a compound having poly(meth)acryloyl group is preferable, examples of the compound include a compound disclosed in Japanese Patent Application Laid-Open No. 2003-292916, or the like.

The energy-curable compound may include a mixture of an organic salt such as an onium salt, or the like, and a compound that includes a plurality of hetero rings in the molecule.
The mixture enables production of ions by cleavage of the organic salt by irradiation with energy beams, use of the ions as an initiating species to induce a ring-opening reaction in relation to the hetero rings and thereby form a three-dimensional network structure.
The organic salt includes an iodonium salt, a phosphonium salt, an antimony salt, a sulphonium salt, a borate salt, or the like.

The hetero ring in the compound that has a plurality of hetero rings in the molecule includes an oxirane, an oxetane, an oxolane, a thriiane, an aziridine, or the like.
More specifically, a compound or the like as disclosed in Curing Techniques, Technical Information Institute, Co., Ltd. (2000) may be used.

Examples of the energy-curable resin include photosensitive reaction group containing polymers or oligomers such as an ester (meta) acrylate having an (meth)acryloyl group on the molecular end, an urethane (meta) acrylate, an epoxy (meta) acrylate, a melamine (meta) acrylate, an acrylic resin (meta) acrylate, thiol-en addition type resin having an allyl group on the molecular end, light cationic polymerization type resin, cinnamoyl group containing polymers such as polyvinyl cinnamate, an amino novolac resin which is diazotized, an acrylic amide type polymers. In particular, an epoxidized polybutadiene, unsaturated polyester, polyglycidylmethacrylate, polyacryl amide, polyvinyl siloxane, and the like may be used as a high-energy-curable resin.
When using the energy-curable resin, the base material is not always required.

It is particularly preferred that the energy-curable adhesive is a combination of an acrylic-base polymer or an acrylic-base polymer that is chemically modified with a functional group that reacts with energy beams (an acrylic polymer having a functional group that reacts with energy beams included in a side chain) and the energy-curable compound (the compound including at least two carbon-carbon double bonds).
This combination is preferred in view of reactivity or operational characteristics due to exhibiting relatively high reactivity with energy beams and enabling selection from a wide range of acrylic adhesives.

An actual example of this type of combination includes a combination of an acrylic polymer having a functional group that reacts with energy beams included in a side chain and a compound including at least two carbon-carbon double bonds (in particular, (meth)acryloyl group). This type of combination includes use of combinations disclosed in Japanese Patent Application Laid-Open No. 2003-292916, or the like.

The acrylic polymer having a functional group that reacts with energy beams included in a side chain can be produced, for example, by bonding an acrylic polymer having a hydroxy group included in a side chain to an isocyanate compound such as 2-isocyanato ethyl acrylate, 2-isocyanato ethyl methacrylate via urethane bond.

The amount of the energy-curable compound is preferably 0.5 to 200 parts by weight, more preferably 5 to 180 parts by weight, and still more preferably 20 to 130 parts by weight relative to 100 parts by weight of the base material (e.g., the acrylic-based polymer described above or an acrylic-based polymer chemically modified with a functional group that reacts with energy beams).

The energy-curable adhesive may include an energy-beam polymerization initiator for causing curing of a compound imparted with energy-curable characteristics for the purpose of improving the reaction speed for forming the three-dimensional network structure.
The energy-beam polymerization initiator includes a known polymerization initiator that is used in response to the type of energy beam such as infrared radiation, visible light, ultraviolet radiation, X rays, electron beams or the like in use. A compound that is adapted for photopolymerization initiation with ultraviolet radiation is preferred in view of operational characteristics.

Typical examples of the energy-beam polymerization initiator include ketone-based polymerization initiator such as benzophenone, acetophenone, quinone, naphthoquinone, anthraquinone, fluorenone; azo-based polymerization initiator such as azobis isobutyronitrile; peroxide-based polymerization initiator such as benzoyl peroxide, perbenzoic acid; or the like. These agents may be used singly or in combinations of two or more agents.
This agent includes commercially available products such as "Irgacure 184 (Registered trademark)" and "Irgacure 651 (Registered trademark)" manufactured by BASF Co. Lte.
The amount of the energy-beam polymerization initiator is normally substantially 0.01 to 10 parts by weight, and preferably substantially 1 to 8 parts by weight relative to the base material.

The energy-beam polymerization initiator and an energy-beam polymerization promoter may be used in combination as required.
In addition to the above components, the energy-curable adhesive may include suitable additives as required such as a cross-linking agent, a curing (cross-linking) promoter, a tackifier, a curing agent, a bodying agent, or the like in order to obtain suitable adhesive characteristics before and after energy curing, and an anti-aging agent, an antioxidant agent, or the like to improve durability. These additives may include any known agent used in this field.

In particular, a preferred configuration of the energy-curable adhesive includes a UV curable adhesive including a UV curable compound in an acrylic adhesive, and more specifically, an acrylic polymer having a functional group that reacts with energy beams included in a side chain, and a UV curable adhesive including an acrylate cross linking agent and an ultraviolet photo-initiator.
The acrylic adhesive having a side-chain functional group that reacts with energy beams is an acrylic polymer in which a (meth)acryloyl group is introduced into a side chain, and may be manufactured by the same manufacturing method as the those compounds described above.
The acrylate cross-linking agent is a low-molecular compound exemplified above such as a compound containing a poly(meth)acryloyl group or a multifunctional acrylate.
The ultraviolet photo-initiator may be a compound as exemplified above such as a typical energy-beam polymerization initiator.

The adhesive that configures the adhesive layer includes a non-energy curable adhesive using an acrylic adhesive as a base material.
In this configuration, the adhesive is suitably configured to have a lower adhesive force than the peel stress when generating a cylindrical rolled body. For example, in a 180 degree peel experiment (25 degrees C) using a silicon mirror wafer as an adherend, an adhesive with no more than 6.5 N/10mm (for example, 0.05 to 6.5 N/10mm, preferably 0.2 to 6.5 N/10mm), and in particular no more than 6.0 N/10mm (for example, 0.05 to 6.0 N/10mm, preferably 0.2 to 6.0 N/10mm) may be used.
Use of this type of adhesive layer for peeling of the sheet from the adherend enables disadvantages such as adherend failure or the like to be inhibited to a minimum.

The non-energy curable adhesive using a base material such as an acrylic-based adhesive having a lower adhesive force is preferably an acrylic-based adhesive by crosslinking a cross-linking agent such as an isocyanate-based cross-linking agent, a melamine-based cross-linking agent, an epoxy-based cross-linking agent, and the like that can react to the reactive functional group to a copolymer.
Here, the copolymer is produced by reacting a C₁ to C₂₀ alkyl (meth)acrylate, a monomer having a reactive functional group, and other copolymezable monomer.
Examples of the C₁ to C₂₀ alkyl (meth)acrylate include methyl (meth)acrylate, ethyl (meth)acrylate, propyl (meth)acrylate, isopropyl (meth)acrylate, butyl (meth)acrylate, isobutyl (meth)acrylate, sec-butyl (meth)acrylate, tert-butyl (meth)acrylate, pentyl (meth)acrylate, isopentyl (meth)acrylate, 2-ethylhexyl (meth)acrylate and octyl (meth)acrylate. Examples of the monomer having a reactive functional group include a carboxyl- or acid anhydride-containing monomer such as acrylic acid, methacrylic acid, itaconic acid, fumaric acid and maleic anhydride; a hydroxyl group-containing monomer such as 2-hydroxyethyl (meth)acrylate; an amino-containing monomer such as morpholino (meth)acrylate; an amide-containing monomer such as (meth)acryl amide. Examples of the other copolymezable monomer include an (meth)acrylate such as an isobornyl (meth)acrylate having an alicyclic hydrocarbon group, vinyl acetate, acrylonitrile, or the like.

Of the above, in view of application characteristics, the use of an energy-curable adhesive and in particular, the use of a UV-curable adhesive is extremely useful in relation to an adhesive for a spontaneously rolling adhesive sheet.
In addition to a base polymer that is generally imparted with adhesive characteristics, the UV-curable adhesive may be configured from an adhesion assisting agent for adjusting the adhesive force or the polymer cohesive characteristics, a UV reactivity diluting agent configured to adjust the viscosity of the adhesive and cause cross linking or curing in response to UV irradiation, or the like. The adhesive may be simply adjusted to have a high adhesive force (or low flexibility) prior to UV irradiation or a low adhesive force (or high flexibility) after UV irradiation.

More specifically, in a dicing process which is an operation in which a semiconductor wafer is formed into small piece chips, as described below, the adhesive sheet of the present invention is adhered to the adherend before the dicing operation At that time, when an indented pattern is present on the surface of the body to be cut such as a semiconductor wafer, an adhesive with a high adhesive force is required in order to enable rapid and accurate recessing of the indented pattern, or in order to inhibit peeling of the protective sheet as a result of the water pressure of the cutting water, the stress due to vibration, or cutting from the dicing blade during dicing. During the peeling operation after the dicing operation, an adhesive with a low adhesive force is required in order to enable rapid execution of the peeling operation and reduction in residual glue on the body to be cut
In this context, a UV-curable adhesive facilitates meeting of these requirements by use of a UV irradiation operation in addition to design of the adhesive composition.
There is no particular limitation in relation to the molecular weight of the base polymer that configures the adhesive, and any adhesive component that is used in this field may be employed. Normally, a molecular weight is expressed as a weight average molecular weight, and for example, may be expressed as a value or the like obtained by conversion of a standard polystyrene reference by a gel permeation chromatography.

The adhesive layer may be formed by a known method in this field such as a method in which a coating liquid that includes an adhesive, an energy-curable compound, and a solvent which is adjusted as required is coated onto the surface of the organic coating layer, a method in which an adhesive layer is formed by coating the coating liquid onto a suitable release liner (separator) and that layer is transferred onto the coating layer, or the like.

When formed by a transfer operation, a void (space) produced in the interface between the adhesive layer and the organic coating is dispersed and eliminated by execution of a heating and pressure process by use of an autoclave process or the like after transfer of the organic coating.
The adhesive layer may either a single layer or a laminated layer.

The adhesive layer may further include addition of beads such as glass beads, resin beads, or the like. The shear storage elastic modulus may be increased by addition of beads to the adhesive layer, and a reduction in the adhesive force can thereby be facilitated.
The average particle diameter of the beads for example, may be 1 to 100 µm, and preferably 1 to 20 µm.
The added amount of beads is for example is 25 to 200 parts by weight, and preferably 50 to 100 parts by weight relative to 100 parts by weight of the total adhesive layer.
In this manner, the effect described above can be maximized, the beads can be uniformly dispersed, and coating of the adhesive is facilitated.

The thickness of the adhesive layer is generally 10 to 200 µm, preferable 20 to 100 µm, and more preferably 30 to 60 µm. In this manner, a sufficient adhesive force can be maintained, and it is possible to retain or temporarily fix the adherend. Furthermore, handling is facilitated.

### <Spontaneously Rolling Adhesive Sheet and Method of Manufacture for Same>

The spontaneously rolling adhesive sheet according to the present invention may be manufactured by stacking in order the shrinkable film layer, the bonding adhesive layer, the rigid film layer, the organic coating layer, and the adhesive layer, and laminating by suitable selective of a laminating means such as a hand roller, a laminator or the like, or a atmospheric air pressure means such as an autoclave, or the like according to a purpose.
Furthermore, manufacturing may be performed in which the bonding adhesive layer is coated/ laminated onto the shrinkable film layer, and then the rigid film layer is laminated thereon, or the shrinkable film layer, the bonding adhesive layer, and the rigid film layer are stacked in order, and then laminated as described above, the organic coating layer is coated/laminated onto the rigid film layer, and then coating/lamination of the adhesive layer is performed thereon.

There is no particular limitation in relation to the shape of these spontaneously rolling adhesive sheets, and the plane shape may be any shape such as a circular shape, an oval shape, a polygonal shape, or the like in accordance with the purpose, the shape is normally quadrilateral. The dimensions thereof may be suitably selected according to the purpose. For example, when the spontaneous rolling feature or the like is considered, the length Lₙ in the rolling direction of the sheet for example is 10 to 2000 mm, and preferably 300 to 1000 mm. Although there is no particular limitation in relation to the length in a direction that is orthogonal to the length Lₙ in these sheets, the length may be 10 to 2000 mm, and 300 to 1000 mm is preferred.
Lₙ denotes a length (diameter when the sheet is circular) in the rolling direction (normally, the direction of principal contraction of the shrinkable film layer) of the spontaneously rolling adhesive sheet (refer to FIG. 2A).

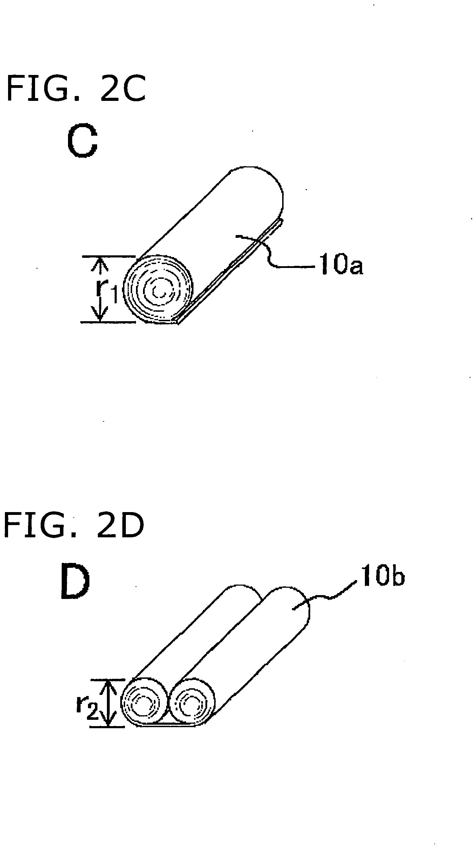

As illustrated in FIG. 2A, the spontaneously rolling adhesive sheet 10 according to the present invention extends in a planar configuration prior to application of a stimulus causing shrinkage of the shrinkable film layer.
When a stimulus such as heating is applied to cause shrinkage of the shrinkable film layer, as illustrated in FIG. 2B, spontaneous rolling starts in one direction from an outer edge portion of the adhesive sheet 10 (normally, the direction of principal contraction of the shrinkable film layer). In this adhesive sheet 10, the adhesive force of the adhesive layer is reduced or eliminated.
Thereafter, the adhesive sheet 10 finishes rolling, and as illustrated in FIG. 2C, a single cylindrical rolled body 10a of diameter r₁ is formed.
Alternatively, after stimulus is applied, when spontaneous rolling starts in two directions from an outer edge portion of the adhesive sheet 10, as illustrated in FIG. 2D, two cylindrical rolled bodies 10b of diameter r₂ are formed.

When the spontaneous rolling adhesive sheet according to the present invention has either configuration of one or two cylindrical rolled bodies formed by spontaneous rolling, the ratio (rₙ/Lₙ) of the diameter of the rolled body rₙ and the length Lₙ in a rolled direction of the sheets is preferably in the range of 0.001 to 0.333, and more preferably 0.01 to 0.2.
When a value for either of the diameter rₙ and the length Lₙ is not fixed, it means that it is the maximum value.
Furthermore, the general value for Lₙ is in the range of 1 to 20 mm.
The value for rₙ/Lₙ is set in the above range by adjustment of the material and/or the thickness or the like of the shrinkable film layer, the bonding adhesive layer, the rigid film layer, or the like.

When the value for rₙ/Lₙ is in this range, suitable spontaneous rolling is achieved in relation to the length and thickness of the sheet, and rapid rolling characteristics can be obtained.
Since the organic coating layer and the adhesive layer in the spontaneous rolling adhesive sheet according to the present invention are extremely thin, the effect on rₙ/Lₙ as a result of the presence or absence of either or both of these layers can be almost completely ignored. Furthermore, it has been confirmed that there is substantially no effect on the behavior of the spontaneous rolling of the adhesive sheet.

The spontaneous rolling adhesive sheet according to the present invention may be provided with a separator (release sheet) on the surface of the adhesive layer in order to protect the adhesive layer.
The constituent material of the separator includes paper, a synthetic resin film such as polyethylene, polypropylene, or polyethylene terephthalate, and the like. As required, a release process such as a silicone process, a long-chain alkyl process, a fluorine process, or the like may be executed to increase the release performance of the surface of the separator from the adhesive layer. Furthermore, as required, an ultraviolet protective process may be executed to prevent a reaction on the adhesive layer as a result of ultraviolet radiation. The thickness of the separator is normally 10 to 200 µm, and preferably is 25 to 100 µm.

### <Application and Method of Use>

The spontaneous rolling adhesive sheet according to the present invention may be employed as a protective or fixing adhesive sheet in relation to a semiconductor wafer, an optical element protective member (for example an optical filter). More specifically, for example, use is possible as an adhesive sheet for back-grinding of a semiconductor (an elemental semiconductor such as Si, Ge, or the like, a compound semiconductor, or the like, same below), an adhesive sheet for a semiconductor or packaging and dicing of a semiconductor, a dicing adhesive sheet for a substrate (a glass plate, a quartz plate, a crystal plate, a ceramic plate, a plastic plate, or the like) that enables formation or installation of an optical element (for example, an optical functional film such as a anti-reflection film or cutting infrared light film, or the like), or similar sheet.
In particular, use is possible as a protective sheet for protecting an adherend from cutting water or corrosion (rust) caused by such water as a result of cutting filings during dicing.
Of the above, use is adapted in relation to a semiconductor adhesive sheet such as a semiconductor protective sheet, a semiconductor wafer fixing adhesive sheet, or the like.

In this manner, the spontaneous rolling adhesive sheet according to the present invention realizes accurate and rapid peeling of the sheet while minimizing stress on the adherend even in relation to an extremely small and/or thin adherend, a low-rigidity adherend, or a high-rigidity or high-toughness adherend (body to be cut).

### <Method of Manufacture of Cut Piece >

The method of manufacturing the cut piece according to the present invention includes the steps of adhering the spontaneous rolling adhesive sheet described above to an adherend, cutting the adherend into small (cut) pieces, and removing the spontaneous rolling adhesive sheet by heating and peeling from the small pieces.
More specifically, the spontaneous rolling adhesive sheet according to the present invention is adhered and temporarily fixed to the adherend, and required processing is executed in relation to the adherend. The processing executed at this time may be exemplified by a processing performed during semiconductor processes, or the like, and for example, may include cutting or the like into small pieces by dicing or the like.
Thereafter, the adhesive force of the adhesive layer of the spontaneous rolling adhesive sheet is reduced. Then, a stimulus such as heating or the like that causes shrinking of the shrinkable film layer is applied to the spontaneous rolling adhesive sheet. The spontaneous rolling adhesive sheet is provided with an energy-curable adhesive layer, and when the shrinkable film layer is a heat shrinking film layer, energy beam irradiation is applied to the adhesive layer, and the shrinkable film layer is heated by a predetermined heating means.

In this manner, the spontaneous rolling adhesive sheet undergoes spontaneous rolling from one end portion in one direction (normally, the direction of principal shrinkage), or from two opposed ends towards the center (normally, to the direction of principal shrinkage), and thereby forms one or two cylindrical rolled bodies, and is peeled from the adherend. In other words, since the adhesive layer is cured, the adhesive force is eliminated, and the shrinkable film layer tends to undergo shrinking deformation, the outer edge portion of the adhesive sheet is raised, and the adhesive sheet is rolled by that outer edge portion (or two opposed outer edge portions), to form one (or two) cylindrical rolled body/bodies by movement in a single direction (or two mutually opposed directions (center direction)).
Rapid cylindrical rolling in one axial direction is enabled by adjustment of the direction of shrinkage of the adhesive sheet by the shrinkable film layer, and alternatively, peeling of the adhesive sheet is enabled in an extremely simple and effective configuration from the adherend.

Since the peeling stress can be minimized and the anchoring characteristics between the rigid film layer and the adhesive layer can be ensured by the organic coating layer, the adhesive amount that remains on the adherend can be dramatically reduced, and contamination of the adherend can be accurately prevented.
Furthermore, the peeling due to rolling is induced by a non-contact external stimulus, and therefore damage or contamination of the adherend due to contact resulting from peeling in a contact manual or machine-based configuration can be prevented.
In particular, since peeling is executed without contact, time or trouble required for removing the adhesive sheet even after ultrafine processing of the adherend can be reduced to a minimum.

When the spontaneous rolling adhesive sheet undergoes spontaneous rolling from one end portion in one direction, a single cylindrical rolled body is formed (unidirectional rolling and peeling), and when the spontaneous rolling adhesive sheet undergoes spontaneous rolling towards the center from two opposed end portions, two cylindrical rolled bodies in parallel are formed (bidirectional rolling and peeling).
In this manner, since the adhesive sheet according to the present invention is constantly rolled into a cylindrical configuration, tape recovery operations after peeling are simplified, and the manufacturing efficiency of the adherend and related products is enhanced.

A representative example of an adherend includes a semiconductor wafer, a glass wafer, a quartz wafer, a crystalline wafer, a ceramic, a dielectric plate, or the like.
There is no particular limitation on the processing as long as the processing is can be used in relation to an adhesive sheet, and for example, includes grinding, cutting, polishing, etching, lathe processing, dicing, and heating (however, when the shrinkable film layer is a thermal shrinkable film layer, there is a limitation to a temperature of no more than the heat shrinking initiation temperature). In particular, use is adapted in relation to processing including cutting into small pieces.
Energy irradiation and heating processing may be performed simultaneously, or may be performed in stages.

The temperature for heating may be suitable selected in response to the shrinking characteristics of the shrinkable film layer, and for example, is 70 to 200 degrees C, and preferably 70 to 160 degrees C. The method of heating includes blowing of heated air, application of a lamp, electromagnetic beams, or the like, exposure to hot water, or immersion in hot water, heating of the adherend, or the like. In addition to uniform heating of the whole surface of the adherend, the heating operation also includes stepwise heating of the whole surface, and in addition, partial heating only for inducing a peeling operation, and suitable selection may be performed in response to the purpose of employing simple peeling characteristics.

According to the spontaneous rolling adhesive sheet of the present invention, the coupling of the shrinkable film layer, the bonding adhesive layer, the rigid film layer, the organic coating layer, and the adhesive layer enables inhibition in particular of the disadvantage associated with deformation due to heating during thermal shrinking, and for example, inhibits friction or the like with respect to a substantially parallel direction in the adherend. In this manner, rapid peeling is enabled without production of residual adhesive (anchor failure) on the spontaneous rolling adhesive sheet.

The spontaneous rolling adhesive sheet according to the present invention will be described in detail below based on the example. However, the present invention is not limited to the following examples.
All percentages and parts expressing the content or amounts used in the Examples are based on weight, unless otherwise specified.

### <Manufacture of Rigid Film Layer 1 including Organic Coating Layer>

A PET film is prepared as the rigid film layer. The PET film is formed from Lumirror S105 (thickness of 38 µm) subjected to single-sided corona processing manufactured by Toray Industries.
The organic coating layer is coated using a gravure coater onto the corona processed side of the rigid film layer to have a dry film thickness of 1 to 2 µm and dried to thereby obtain a rigid film layer 1.
A light blue printing ink NB300 (manufactured by Dainichiseika) is used in the organic coating layer. NB300 includes a polyurethane vinyl acetate-vinyl chloride copolymer as a binder resin, and a strength peak has been confirmed in relation to urethane by use of IR.

### <Manufacture of Rigid Film Layer 2 including Organic Coating Layer>

A PET film is prepared as the rigid film layer. The PET film is formed from Lumirror S105 (thickness of 38 µm) subjected to single-sided corona processing manufactured by Toray Industries.
The organic coating layer is coated using a gravure coater onto the corona processed side of the rigid film layer to have a dry film thickness of 1 to 2 µm and dried to thereby obtain a rigid film layer 2.
NB300 (manufactured by Dairuchiseika) free of a light blue printing ink is used in the organic coating layer. NB300 includes a polyurethane vinyl acetate-vinyl chloride copolymer as a binder resin, and a strength peak has been confirmed in relation to urethane by use of IR.

### <Manufacture of Rigid Film Layer 3 including Organic Coating Layer>

A PET film is prepared as the rigid film layer. The PET film is formed from Lumirror S105 (thickness of 38 µm) subjected to single-sided corona processing manufactured by Toray Industries.
The organic coating layer is coated using a gravure coater onto the corona processed side of the rigid film layer to have a dry film thickness of 1 to 2 µm and dried to thereby obtain a rigid film layer 3.
An ethyl acetate solution containing 71 parts by weight of ADEKABON TITER U500 (manufactured by ADEKACORPORATION, which is a polyurethane primer agent) and 28 parts by weight of CLOLNATE HL (manufactured by Nippon Polyurethane industry CO., LTD., which is an isocyanate resin) is used for an organic coating layer.

### <Manufacture of Rigid Film Layer 4 including Organic Coating Layer>

50.0 parts of t-butyl acrylate, 30.0 parts of acrylic acid, and 20.0 parts of butyl acrylate as the acrylic monomers, 1.0 part of trimethylol propane triacrylate as multifunctional monomer, 0.1 part of 1-[4-(2-hydroxyethoxy)-phenyl]-2-hydroxy -2-methyl-1-propane-1-one (Tradename "IRGACURE 2959", manufactured by BASF) as a photopolymerization initiator, 73.4 parts of polyoxy tetramethylene glycol (molecular weight 650, manufactured by Mitsubishi Chemical) as a polyol, and 0.05 parts of dibutyl tin dilaurate as a urethane reaction catalyst are introduced and stirred, 26.6 parts of xylylene diisocyanate is added in the form of drops as a polyisocyanate, and reacted for two hours at 65 degrees C to thereby obtain a urethane polymer-acrylic monomer mixture. The used amount of the polyol component and the polyisocyanate component is NCO/OH (equivalence ratio) = 1.25.
The resulting urethane polymer-acrylic monomer mixture is coated onto a polyethylene terephthalate film having a thickness of 38 µm (tradename "S-10" manufactured by Toray Industries) so that the thickness after curing is 3 to 4 µm. Onto this layer, a PET film subjected to surface processing (thickness 38 µm) is stacked and covered, and curing is performed by irradiating ultraviolet radiation (luminance 163 mw/cm², luminous energy 2100 mJ/cm²) using a high-pressure mercury lamp onto the covered PET film to thereby obtain a polyethylene terephthalate/acryl-urethane laminated sheet as a rigid film layer 4 including an organic coating layer.

### <Manufacture of Rigid Film Layer 5 including Organic Coating Layer>

A PET film is prepared as the rigid film layer. The PET film is formed from Lumirror S105 (thickness of 38 µm) subjected to single-sided corona processing manufactured by Toray Industries.
The organic coating layer is coated using a gravure coater onto the corona processed side of the rigid film layer to have a dry film thickness of 1 to 2 µm and dried to thereby obtain a rigid film layer 5.
A blue printing ink CVL-PR (manufactured by DIC Graphics) is used in the organic coating layer. CVL-PR includes vinyl acetate containing hydroxyl groups-vinyl chloride copolymer as a binder resin, and a strength peak has not been confirmed in relation to urethane by use of IR.

### <Manufacture of Rigid Film Layer 6 including Organic Coating Layer>

A PET film is prepared as the rigid film layer. The PET film is formed from Lumirror S105 (thickness of 38 µm) subjected to single-sided corona processing manufactured by Toray Industries.
The organic coating layer is coated using a gravure coater onto the corona processed side of the rigid film layer to have a dry film thickness of 1 to 2 µm and dried to thereby obtain a rigid film layer 6.
An amorphous saturated copolymerzing polyester resin (tradename "Vylon" manufactured by TOYOBO Co., Ltd.) is used as the organic coating layer.

### <Preparation of Spontaneously Rolling Adhesive Sheet 1>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the non-corona processed surface of a PET film (Lumirror S105, manufactured by Toray Industries, single-sided corona processed, film thickness of 38 µm, no organic coating processing) to have a dry film thickness of 2 to 4 µm, and thereby form the bonding adhesive layer 1.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 1.

### <Preparation of Spontaneously Rolling Adhesive Sheet 2>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the noun-corona processed surface of the rigid film layer 1 to have a dry film thickness of 2 to 4 µm, and thereby form the bonding adhesive layer 2.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 2.

### <Preparation of Spontaneously Rolling Adhesive Sheet 3>

A bonding adhesive agent is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the noun-corona processed surface of the rigid film layer 2 to have a dry film thickness of 2 to 4 µm, and thereby form the bonding adhesive layer.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 3.

### <Preparation of Spontaneously Rolling Adhesive Sheet 4>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the non-corona processed surface of the rigid film layer 3 to have a dry film thickness of 2 to 4 µm, and thereby form the bonding adhesive layer.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 4.

### <Preparation of Spontaneously Rolling Adhesive Sheet 5>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the non-corona processed surface of the rigid film layer 4 to have a dry film thickness of 2 to 4 µm, and thereby form the bonding adhesive layer.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 5.

### <Preparation of Spontaneously Rolling Adhesive Sheet 6>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the non-corona processed surface of the rigid film layer 5 to have a dry film thickness of 2 to 4 µm, and thereby form the bonding adhesive layer.
Immediately after coating of the bonding adhesive layer 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 6.

### <Preparation of Spontaneously Rolling Adhesive Sheet 7>

A bonding adhesive is prepared by mixing TAKELAC A520 manufactured by Mitsui Chemicals, TAKENATE A10 also manufactured by Mitsui Chemicals, and ethyl acetate in the weight ratio of 6: 1: 5.5. The mixture is coated using a gravure coater onto the non-corona processed surface of the rigid film layer 6 to have a dry film thickness of 2 to 4 µm, and thereby form the bonding adhesive layer.
Immediately after coating of the bonding layer adhesive 1, the corona processed surface of the single-sided corona processed thermal shrinking polyester film (Spaceclean S7200, manufactured by Toyobo Co., Ltd., film thickness 30 µm) is adhered to thereby prepare a spontaneously rolling laminated sheet 7.

### <Preparation of Adhesive 1>

An acrylic polymer (weight average molecular weight 700,000) was obtained by copolymerization from a toluene solution to which 0.2 parts by weight of a polymerization initiator, benzyl peroxide is added to 100 parts by weight of a mixture having a molar ratio of 75:25:20 of 2-ethylhexyl acrylate: morpholyl acrylate : 2-hydroxyethyl acrylate.
An acrylic polymer having a methacrylate group in a side chain was manufactured by mixing 0.03 parts by weight of dibutyltin dilaurate as an addition reaction catalyst relative to 100 parts by weight of the resulting acrylic polymer and 2-isocyanatoethyl methacrylate (Karenz MOI; manufactured by Showa Denko K.K) corresponding to 50 mol% of the hydrogen groups originating in the 2-hydroxyhexyl acrylate in the obtained acrylic polymer, and then reacting for 24 hours at 50 degrees C in an atmosphere of air.
A mixture was obtained by adding 15 parts by weight of a trifunctional acrylic photopolymerizable monomer (trimethylolpropane triacrylate) (Tradename: ARONIX M320 manufactured by Toagosei Co., Ltd.), one part by weight of a radical photopolymerization initiator (IRGACURE 651, 2,2-dimethoxy-1, 2-diphenylethane -1-one manufactured by BASF, and one part by weight of an isocyanate compound (manufactured by Nippon Polyurethane Industries Co., Ltd., Trade name "CORONATE L"), with respect to 100 parts by weight of the resulting acrylic polymer.
The resulting mixture was coated using a die coater onto the release processed surface of a PET film MRF38 that has been subjected to release processing (manufactured by Mitsubishi Polyester Film Corporation) to obtain a dry film thickness of 30 µm. The PET film MRF38 that has been subjected to release processing is used as the separator.

### <Preparation of Adhesive 2>

An acrylic polymer (weight average molecular weight 700,000) was obtained by copolymerization from a toluene solution to which 0.2 parts by weight of a polymerization initiator, benzyl peroxide is added to 100 parts by weight of a mixture having a molar ratio of 50:50:20 of butyl acrylate: ethyl acrylate: 2-hydroxyethyl acrylate.
An acrylic polymer having a methacrylate group in a side chain was manufactured by mixing 0.03 parts by weight of dibutyltin dilaurate as an addition reaction catalyst relative to 100 parts by weight of the resulting acrylic polymer and 2-isocyanatoethyl methacrylate (Karenz MOI; manufactured by Showa Denko K.K) corresponding to 80 mol% of the hydrogen groups originating in the 2-hydroxyhexyl acrylate in the obtained acrylic polymer, and then reacting for 24 hours at 50 degrees C in an atmosphere of air.
A mixture was obtained by adding 15 parts by weight of a trifunctional acrylic photopolymerizable monomer (trimethylolpropane triacrylate) (Tradename: ARONIX M320 manufactured by Toagosei Co., Ltd.), one part by weight of a radical photopolymerization initiator (IRGACURE 651, 2,2-dimethoxy-1, 2-diphenylethane -1-one manufactured by BASF), and one part by weight of an isocyanate compound (manufactured by Nippon Polyurethane Industries Co., Ltd., Trade name "CORONATE L"), with respect to 100 parts by weight of the resulting acrylic polymer.
The resulting mixture was coated using a die coater onto the delaminating processed surface of a PET film MRF38 that has been subjected to release processing (manufactured by Mitsubishi Polyester Film Corporation) to obtain a dry film thickness of 30 µm. The PET film MRF38 that has been subjected to release processing is used as the separator.

### <Preparation of Adhesive 3>

An acrylic polymer (weight average molecular weight 1,000,000) was obtained by copolymerization from an ethyl acetate solution to which 0.2 parts by weight of a polymerization initiator, benzyl peroxide is added to 100 parts by weight of a mixture having a weight ratio of 70:30:10 of methyl acrylate: 2-hydroxyethyl acrylate: acrylic acid.
A mixture was obtained by adding 3 part by weight of an isocyanate compound (manufactured by Nippon Polyurethane Industries Co., Ltd., Trade name "CORONATE L"), 0.75 part by weight of an epoxy-based cross-linking agent (Tetrat C, Mitsubishi gas chemical company, Inc.), 50 parts by weight of a multifunctional urethane acrylate oligomer (KAYARAD DPHA-4OH, Nippon Kayaku Co.,Ltd), 3 parts by weight of a photopolymerization initiator (IRGACURE 651, manufactured by BASF), with respect to 100 parts by weight of the resulting acrylic copolymer.
The resulting mixture was coated using a die coater onto the delaminating processed surface of a PET film MRF38 that has been subjected to release processing (manufactured by Mitsubishi Polyester Film Corporation) to obtain a dry film thickness of 30 µm. The PET film MRF38 that has been subjected to release processing is used as the separator.

### Example 1

The adhesive 2 was adhered to the organic coating layer side of the PET base surface of the spontaneously rolling laminated sheet 2 to thereby prepare a spontaneously rolling adhesive sheet.

### Example 2

The adhesive 3 was adhered to the organic coating layer side of the PET base surface of the spontaneously rolling laminated sheet 2 to thereby prepare a spontaneously rolling adhesive sheet.

### Example 3

The adhesive 2 was adhered to the organic coating layer side of the PET base surface of the spontaneously rolling laminated sheet 3 to thereby prepare a spontaneously rolling adhesive sheet.

### Example 4

The adhesive 2 was adhered to the organic coating layer side of the PET base surface of the spontaneously rolling laminated sheet 4 to thereby prepare a spontaneously rolling adhesive sheet.

### Example 5

The adhesive 2 was adhered to the organic coating layer side of the PET base surface of the spontaneously rolling laminated sheet 5 to thereby prepare a spontaneously rolling adhesive sheet

### Comparative Example 1

The adhesive 1 was adhered to the PET base surface of the spontaneously rolling laminated sheet 1 to thereby prepare a spontaneously rolling adhesive sheet.

### Comparative Example 2

The adhesive 2 was adhered to the PET base surface of the spontaneously rolling laminated sheet 1 to thereby prepare a spontaneously rolling adhesive sheet.

### Reference Example 3

The adhesive 2 was adhered to the PET base surface of the spontaneously rolling laminated sheet 6 to thereby prepare a spontaneously rolling adhesive sheet.

### Reference Example 4

The adhesive 2 was adhered to the PET base surface of the spontaneously rolling laminated sheet 7 to thereby prepare a spontaneously rolling adhesive sheet.

The characteristics of the spontaneously rolling adhesive sheet obtained in the example, the comparative example and the reference example were evaluated using the following method.

### Peel Test

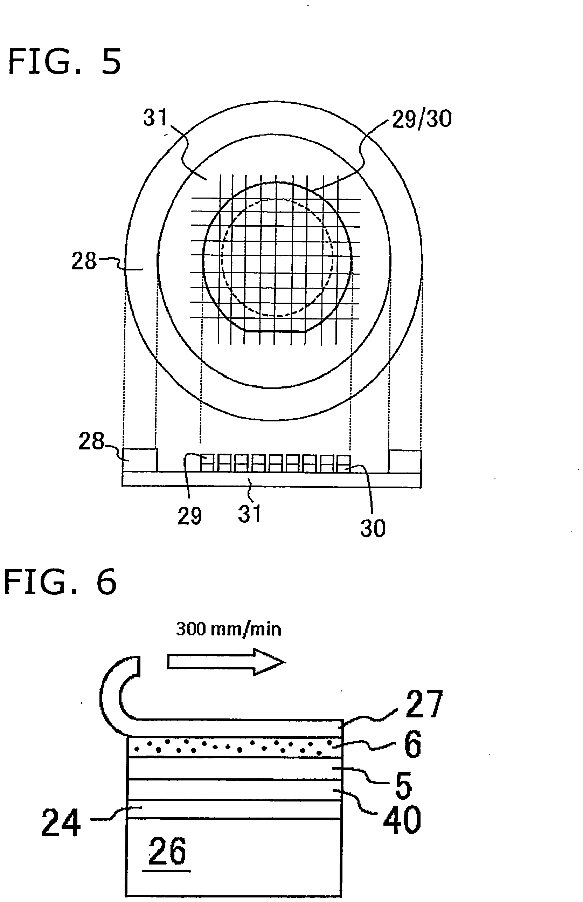

As illustrated in FIG. 5, the respective spontaneously rolling adhesive sheet 29 obtained above was adhered to an 8-inch silicon mirror wafer 30 (manufactured by Tokyo Kakoh), and the wafer was ground to a thickness of 200 µm using back-grinding apparatus DFG8560 manufactured by DISCO Corporation.
A dicing tape 31 (DU400SE manufactured by Nitto Denko Corporation) was adhered to the grinding surface of the silicon mirror wafer, and then a dicing ring 28 was installed. This configuration was subjected to dicing in a 7.5 x 7.5 mm square shape using a dicing apparatus DFD651 manufactured by DISCO Corporation.
200 small pieces configured by dicing were peeled in an arbitrary manner from a region within an inscribed circular fracture line on the silicon mirror wafer 30 in FIG. 5 and subjected to UV irradiation at 300 mJ/cm² from the side having the spontaneously rolling adhesive sheet 29 using a NEL UM810 (high-pressure mercury lamp 20 mW/cm²) manufactured by Nitto Seiki Co., Ltd.
After the UV irradiation operation, the small pieces were disposed on a hotplate heated to 100 degrees C (the surface for disposition is the side without attachment of the spontaneously rolling adhesive sheet), and the peeling characteristics were evaluated. The results are shown in Table 1.
When all pieces peel within one minute after disposing on the hotplate without any anchor failure of the adhesive layer: O
When all pieces peel within one minute after disposing on hotplate with partial anchor failure of the adhesive layer: (number of pieces not exhibiting partial anchor failure)/200
Even one example of anchor failure over the whole surface during peeling after disposition on hotplate: X

### Anchor Failure Testing

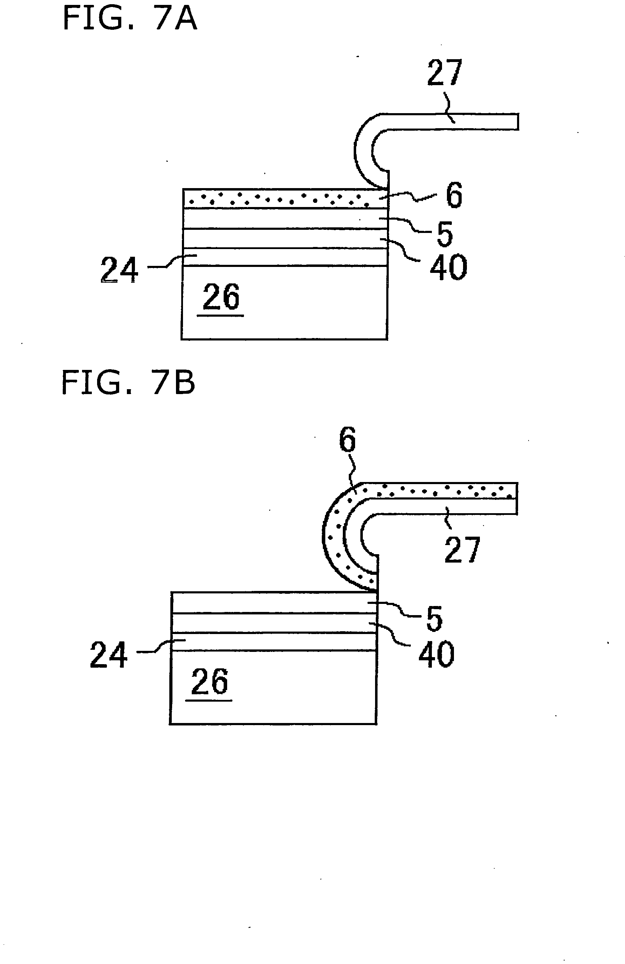

As illustrated in FIG. 5, firstly, the separator is removed from the resulting spontaneously rolling adhesive sheet, and the adhesive surface of the adhesive tape 27 (Nitto Denko Corporation, BT315) is adhered using a hand roller on the side with the adhesive layer 6.
UV irradiation at 300 mJ/cm² was applied to the spontaneously rolling adhesive sheet using a NEL UM810 (high-pressure mercury lamp 20 mW/cm²) manufactured by Nitto Seiki Co., Ltd. from the side with the rigid film layer of the spontaneously rolling laminated sheet 40 to thereby cure the adhesive layer 6.
Then, double-sided tape 24 (Nitto Denko Corporation, No. 5000N) is adhered to the rigid film side of the spontaneously rolling laminated sheet 40 to thereby prepare a 10 mm x 70 mm strip specimen. Thereafter, a 2 mm thickness SUS plate 26 is adhered to the other side of the double-sided tape 24 to thereby prepare a test piece.
The adhesive tape 27 in the resulting test piece is peeled using a 180 degree peel at 300 mm/min and, as illustrated in FIG. 7A, a result of O was obtained when only the adhesive tape 27 underwent peeling (no occurrence at all of anchor failure). As illustrated in FIG. 7B, the peel force was measured in relation to those examples (of anchor failure) occurring when both the adhesive tape 27 and the adhesive layer 6 were peeled together. The results are shown in Table 1.
The adhesive force when directly adhering the adhesive tape 27 to the SUS plate 26 is 7 N/10mm, and those examples exhibiting no anchor failure during testing exhibited an equivalent adhesive force. Therefore, the adhesive layer in examples 1 to 4 are confirmed to exhibit extremely superior anchor characteristics in relation to the spontaneously rolling adhesive sheet after UV curing.

**[Table 1-1]**

| | Example 1 | Example 2 | Example 3 | Example 4 | Example 5 |
|---|---|---|---|---|---|
| Shrinkable Film Layer | Single-side Corona-Processed Heat Shrinkable Polyester Film (film thickness 30 µm) | | | | |
| Bonding Adhesive Layer | TAKELAC A520/ TAKENATE A10 (film thickness 2 - 4 µm) | | | | |
| Rigid Film Layer | Single-side Corona-Processed PET Film (film thickness 38µm) | | | | |
| Organic Coating Layer (film thickness) | Polyurethane vinyl acetate-vinyl chloride copolymer/ Colorant containing layer (1~2µm) | Polyurethane vinyl acetate-vinyl chloride copolymer/ Colorant containing layer (1~2µm) | Polyurethane vinyl acetate-vinyl chloride copolymer containing layer (1~2µm) | Urethane resin layer (1~2µm) | Acrylic urethane resin layer (3~4µm) |
| Spontaneously Rolling Laminated Sheet | Spontaneously Rolling Laminated Sheet 2 | Spontaneously Rolling Laminated Sheet 2 | Spontaneously Rolling Laminated Sheet 3 | Spontaneously Rolling Laminated Sheet 4 | Spontaneously Rolling Laminated Sheet 5 |
| Adhesive Layer | Adhesive 2 | Adhesive 3 | Adhesive2 | Adhesive 2 | Adhesive 2 |
| Peel Test | O | O | O | O | O |
| Adhesive Force after UV Curing | 0.08 N/10mm | 0.07 N/10mm | 0.08 N/10mm | 0.08 N/10mm | 0.10 N/10mm |
| Anchor Failure Test after UV Curing | O | O | O | O | O |

**[Table 1-2]**

| | Comp. Ex. 1 | Comp. Ex. 2 | Reference Ex. 3 | Reference Ex. 4 |
|---|---|---|---|---|
| Shrinkable Film Layer | Single-side Corona-Processed Heat Shrinkable Polyester Film (film thickness 30 µm) | | | |
| Bonding Adhesive Layer | TAKELAC A520/TAKENATE A10 (film thickness 2-4 µm) | | | |
| Rigid Film Layer | Single-side Corona-Processed PET Film (film thickness 38µm) | | | |
| Organic Coating Layer (film thickness) | non | non | vinyl acetate (containing hydroxy group) -vinyl chloride copolymer/Colora nt containing layer (1 ~ 2µm) | Polyester resin layer (1 ~ 2µm) |
| Spontaneously Rolling Laminated Sheet | Spontaneously Rolling Laminated Sheet 1 | Spontaneously Rolling Laminated Sheet 1 | Spontaneously Rolling Laminated Sheet 6 | Spontaneously Rolling Laminated Sheet 7 |
| Adhesive Layer | Adhesive 1 | Adhesive 2 | Adhesive 2 | Adhesive 2 |
| Peel Test | 194/200 | o | o | o |
| Adhesive Force after UV Curing | 0.37 N/10mm | 0.08 N/10mm | 0.08 N/10mm | 0.08 N/10mm |
| Anchor Failure Test after UV Curing | 0.10 N/10mm | 0.06 N/10mm | 0.11 N/10mm | 0.08 N/10mm |

The spontaneously rolling adhesive sheet according to the present invention exhibits applications as an adhesive sheet when glass, a dielectric body, or the like is used as an adherend in addition to applications as a re-peelable adhesive sheet such as a wafer protective adhesive sheet, a wafer temporary fixing adhesive sheet used in processing steps for a semiconductor silicon wafer, or the like.

## Claims

1. A spontaneously rolling adhesive sheet that can spontaneously roll from one end in one direction, or two opposed ends towards the center as a result of thermal stimulus to thereby form one or two cylindrical rolled bodies comprising:
a spontaneously rolling laminated sheet configured by lamination in the order of a shrinkable film layer which has a principal shrinking characteristic in one predetermined axial direction, a bonding adhesive layer and a rigid film layer,
an adhesive layer laminated onto the rigid film layer side of the spontaneously rolling laminated sheet, and
an organic coating layer disposed between the rigid film layer and the adhesive layer.

2. The spontaneously rolling adhesive sheet according to claim 1, wherein
the organic coating layer is formed from an urethane-based polymer or oligomer.

3. The spontaneously rolling adhesive sheet according to claim 2, wherein
the urethane-based polymer or oligomer of the organic coating layer is obtained by reacting a polyol compound, with a polyisocyanate compound that includes an equivalent amount or excess equivalent amount of isocyanate groups relative to the hydroxyl groups of the polyol compound.

4. The spontaneously rolling adhesive sheet according to any one of claims 1 to 3,
wherein
the adhesive layer is formed from an energy-curable adhesive.

5. The spontaneously rolling adhesive sheet according to claim 4, wherein
the adhesive force of the adhesive layer relative to a silicon mirror wafer (25 degrees C, 180 degree peeling, tensile speed 300 mm/min) is at least 1.0 N/10mm prior to energy irradiation

6. The spontaneously rolling adhesive sheet according to claim 5, wherein
the adhesive layer exhibits a Young's modulus after energy irradiation of 0.4 to 75 MPa at 80 degrees C.

7. The spontaneously rolling adhesive sheet according to any one of claims 1 to 6,
wherein
shrinkage ratio in the principal shrinking direction of the shrinkable film configuring the shrinkable film layer is 30 to 90 % in a predetermined temperature within 70 to 180 degrees C.

8. The spontaneously rolling adhesive sheet according to any one of claims 1 to 7,
wherein
product of the thickness of the rigid film layer by Young's modulus of the rigid film layer is no more than 3.0 x 10⁵N/m.

9. The spontaneously rolling adhesive sheet according to any one of claims 1 to 8,
wherein
the bonding adhesive layer is formed from an urethane-based bonding adhesive, and the peeling force when the shrinkable film layer is peeled away with the rigid film layer at 70 degrees C by 180 degree peeling and tensile speed 300 mm/ min exhibits at least 20 N/10 mm.

10. The spontaneously rolling adhesive sheet according to any one of claims 1 to 9,
wherein
ratio (rₙ/Lₙ) of the diameter of the rolled body rₙ and the length Lₙ in a rolled direction of the sheets is in the range of 0.001 to 0.333 when the spontaneous rolling adhesive sheet has either configuration of one or two cylindrical rolled bodies formed by spontaneous rolling.

11. A method of manufacturing a cut piece comprising;
adhering the spontaneous rolling adhesive sheet of claim 1 to an adherend;
cutting the adherend into a small piece, and
removing the spontaneous rolling adhesive sheet by heating and peeling from the small pieces to obtain the cut piece.

12. The spontaneously rolling adhesive sheet according to claim 1, wherein
the adherend is a semiconductor wafer or an optical element protective member.
